# EUROPEAN PATENT APPLICATION

(11) **EP 4 600 401 A2**
(43) Date of publication of application: **13.08.2025**
(21) Application number: 25156117.1
(22) Date of filing: 05.02.2025
(51) Int. Cl.: C23C 14/00, C23C 14/06, C23C 14/35

(54) **METHOD OF PREPARING SELENIUM OR SULFUR DOPED TELLURIUM OXIDE THIN FILM AND THIN FILM TRANSISTOR USING SPUTTERING**

(30) Priority: 06.02.2024 KR 20240018222; 15.11.2024 KR 20240163260
(71) Applicant: POSTECH Research and Business Development Foundation, Pohang-si, Gyeongsangbuk-do 37673 (KR)
(72) Inventor: NOH, Yong Young, 37673 Pohang-si (KR); CHOI, Taesu, 37673 Pohang-si (KR)
(74) Representative: Stolmár & Partner Patentanwälte PartG mbB

(57) **Abstract**

Disclosed is a method of preparing a tellurium oxide thin film and a thin film transistor using sputtering. In detail, a method of preparing the semiconductor thin film, the method comprising: (a) providing a target comprising a chalcogen atom and a tellurium atom (Te) comprising at least one selected from the group consisting of sulfur atoms (S) and selenium atoms (Se); and (b) preparing a semiconductor thin film comprising an amorphous p-type semiconductor by co-deposition on a substrate using the target in an atmosphere of a mixed gas comprising argon gas and oxygen gas by a sputtering method. The semiconductor thin film channel layer according to the present disclosure has the effect of providing a thin film transistor (TFT) exhibiting excellent output/transfer characteristics and excellent electrical performance with high hole field effect mobility and an on/off current ratio of ~10⁵.

## Description

### CROSS REFERENCE TO RELATED APPLICATION

The present application claims priority to Korean Patent Application No. 10-2024-0018222, filed February 06, 2024, and Korean Patent Application No. 10-2024-0163260, filed November 15, 2024, the entire contents of which are incorporated herein for all purposes by these references.

### BACKGROUND OF THE DISCLOSURE

### 1. Field of the Disclosure

The present disclosure relates to a method of preparing tellurium oxide thin film and thin film transistor using sputtering.

### 2. Description of the Related Art

Over the past several decades, metal oxide semiconductors have promoted great advances in modern optoelectronic research and have been widely used in transistors, photovoltaics, thermoelectrics, light-emitting diodes, displays, etc. However, commercially available oxide semiconductors with high electrical performance are all n-type semiconductors that are efficient only in electron transport at room temperature. And there is no p-type semiconductor that can transport holes, which limits their application in various fields. A representative n-type semiconductor, amorphous a-InGaZnO has been commercialized as a backplane transistor that drives organic light-emitting diode (OLED) displays. The high dispersion conduction band minimum (CBM) enables excellent electron transport characteristics even in an amorphous structure, but there is a problem that p-type characteristics cannot be shown at room temperature.

Materials such as CuₓO and SnO have been studied as p-type metal oxide semiconductors that can transport holes even at room temperature. But compared to n-type metal oxides, they show poor electrical performances such as low hole field effect mobility and low on/off current ratios, which significantly limit the development of pn junction diode-based optoelectronics and CMOS (Complementary Metal Oxide Semiconductor) circuits.

The main reason why metal oxide semiconductors have poor p-type characteristics is that the valence band maximum for hole transport in metal oxides is mainly anisotropic and relatively small in size, consisting of highly localized oxygen 2p orbitals. In addition, the metastable cationic valence states of Cu⁺ and Sn²⁺ are unstable in air condition, so their ambient stability is poor. In this regard, the development of stable, low-cost, and high-mobility p-type semiconductors is very important in the current microelectronics industry.

### SUMMARY OF THE DISCLOSURE

The purpose of the present disclosure is to solve the above problems, and to provide a process technology for implementing high-performance M (M is Se or S) alloyed TeOₓ thin films by sputtering and optimizing the composition and alloy amount to control charge and mobility.

In addition, another purpose of the present disclosure is to provide a novel amorphous p-type semiconductor of TeOₓ:M using a sputtering deposition technique and to provide a high-performance p-channel transistor using it as a semiconductor thin film.

In addition, another purpose of the present disclosure is to provide a method for preparing a high-performance p-channel TeOₓ:M thin film transistor with high stability and high performance at a low processing temperature using sputtering.

In addition, another purpose of the present disclosure is to provide a large-area flexible thin film transistor using the method using low-cost sputtering.

One aspect of the present disclosure provides a method of preparing a semiconductor thin film, the method comprising: (a) providing a target comprising a tellurium atom (Te) and a chalcogen atom comprising at least one selected from the group consisting of a sulfur atom(S) and a selenium atom(Se); and (b) preparing the semiconductor thin film comprising an amorphous p-type semiconductor by performing co-deposition on a substrate by sputtering method using the target under an atmosphere of a mixed gas comprising an argon gas and an oxygen gas.

In addition, the step (a) may comprise (a-1) providing a first target comprising a tellurium atom (Te); and (a-2) providing a second target comprising a chalcogen atom.

In addition, the step (a) may be a step of (a') providing a target comprising a mixture of a tellurium atom (Te) and a chalcogen atom comprising at least one selected from the group consisting of a sulfur atom (S) and a selenium atom (Se).

In addition, the step (b) may comprise (b-1) discharging an argon plasma under an atmosphere of an argon gas; and (b-2) colliding the argon plasma with the first target and the second target under an atmosphere of a mixed gas comprising an argon gas and an oxygen gas to co-deposit at least one selected from the group consisting of the atom of the first target, the atom of the second target and an oxide thereof on the substrate, thereby preparing the semiconductor thin film comprising a tellurium composite.

In addition, the plasma discharge pressure of the step (b-1) may be in a range of 1 to 15 Pa.

In addition, a process working pressure, which is a total pressure of the argon gas and the oxygen gas in the step (b-1) or the step (b-2), may be in a range of 1 Pa or less, preferably 0.1 to 0.65 Pa.

In addition, a total flow rate of the argon gas and the oxygen gas in the step (b-1) or step (b-2) may be in a range of 5 to 50 sccm.

In addition, in the step (b), a ratio (P_{O2}/ (P_{Ar}+P_{O2})) of an oxygen gas partial pressure (P_{O2}) to a total pressure of the argon gas and the oxygen gas (P_{Ar} + P_{O2}) may be in a range of 0 to 50%.

In addition, in the step (b), an oxygen content of the amorphous p-type semiconductor may be regulated by controlling a ratio (P_{O2}/ (P_{Ar}+P_{O2})) of an oxygen gas partial pressure (P_{O2}) to a total pressure (P_{Ar}+P_{O2}) of the argon gas and the oxygen gas.

In addition, in the step (b-2), the power (W_{T1}) applied to the first target may be 10 to 30 W, and the power (W_{T2}) applied to the second target may be 1 to 9 W.

In addition, the step (b) may be carried out at room temperature.

In addition, the temperature of the substrate in the step (b) may be at a range of 5 to 50 °C.

In addition, the method may further comprise, after the step (b): (c) annealing the semiconductor thin film at a temperature in a range of 200 to 300 °C in air.

In addition, the thickness of the semiconductor thin film may be 2 to 100 nm.

In addition, the amorphous p-type semiconductor may comprise a chalcogen atom comprising at least one selected from the group consisting of a selenium atom (Se) and a sulfur atom (S); and a tellurium composite comprising a tellurium atom (Te) and a tellurium oxide.

In addition, the chalcogen atom may be alloyed with the tellurium composite.

In addition, the p-type semiconductor may be represented by chemical formula 1 below.

[Chemical Formula 1] TeOₓ:M

in chemical formula 1, M is sulfur atom (S) or selenium atom (Se), and x is 0.8≤x≤1.7.

In addition, x may be characterized by 1.0≤x≤1.6.

In addition, the tellurium atom of the amorphous p-type semiconductor may comprise an ionization state of Te⁴⁺, an ionization state of Te²⁺, and a non-ionization state of Te⁰.

In addition, the tellurium oxide may comprise a tellurium monoxide (TeO) and a tellurium dioxide (TeO₂).

In addition, the semiconductor may be in an oxygen-deficient state.

In addition, the selenium atom of the semiconductor may comprise an ionization state of Se²⁻.

In addition, the semiconductor may be used for a semiconductor thin film of a thin film transistor.

Another aspect of the present disclosure provides a method of fabricating a thin film transistor, the method comprising: (1) preparing a laminate comprising a gate electrode and an insulating layer positioned on the gate electrode; (2) forming a semiconductor thin film prepared by the method on the insulating layer of the laminate, wherein the semiconductor thin film comprises a semiconductor; and (3) forming a source electrode and a drain electrode on the semiconductor thin film.

Another aspect of the present disclosure provides a semiconductor thin film, the semiconductor thin film may comprise an amorphous p-type semiconductor, wherein the semiconductor thin film is prepared by the method, and the amorphous p-type semiconductor comprises a chalcogen atom comprising at least one selected from the group consisting of a selenium atom (Se) and a sulfur atom (S), and a tellurium composite comprising a tellurium atom (Te) and a tellurium oxide.

The semiconductor thin film channel layer comprising TeOₓ:Se prepared according to the method for preparing a semiconductor thin film according to the present disclosure has the effect of providing a thin film transistor (TFT) exhibiting excellent output/transfer characteristics and excellent electrical performance with high hole field effect mobility and an on/off current ratio of ~10⁵.

### BRIEF DESCRIPTION OF THE DRAWINGS

Since the accompanying drawings are for reference in describing exemplary Examples of the present disclosure, the technical spirit of the present should not be construed as being limited to the accompanying drawings, in which:
FIG. 1 is a schematic diagram showing a method for preparing a semiconductor thin film for use in an amorphous selenium-alloyed p-type thin-film transistor using a sputtering process according to the present disclosure.
FIG. 2 shows an XPS analysis photograph of Example 6 of the present disclosure.
FIG. 3 shows an XPS analysis graph of Example 6 of the present disclosure and Comparative Example 1.
FIG. 4 is a graph showing the results of measuring the Extended X-ray absorption fine structure (EXAFS) of the thin film of Example 6 of the present disclosure.
FIG. 5 is a graph showing the results of the XRD (X-ray Diffractometer) spectrum of the sample immediately after sputtering of Example 1 and the TeOₓ:Se thin film annealed at 225 °C.
FIG. 6 is a drawing showing the band gap calculated by measuring the transmittance of the thin films according to Examples 2, 4, and Comparative Example 1 in the range of 200 nm to 2500 nm and using the tauc plot.
FIG. 7 is a graph showing the transfer characteristics of each according to the selenium alloy ratio of the selenium (Se)-doped TeOx:Se thin film transistors (TFTs) deposited by the sputtering process according to Examples 1, 2, 3, and 5 and the selenium (Se)-undoped TeOx thin film transistors (TFTs) according to Comparative Example 1, depending on the selenium alloy ratio.
FIG. 8 is a graph showing the transfer characteristics of the devices of the selenium (Se)-doped TeOₓ:Se thin film transistors (TFTs) of Examples 6, 7, and 8 according to the oxygen partial pressure.

### DESCRIPTION OF THE PREFERRED EMBODIMENTS

Herein after, examples of the present disclosure will be described in detail with reference to the accompanying drawings in such a manner that the ordinarily skilled in the art can easily implement the present disclosure.

The description given below is not intended to limit the present disclosure to specific Examples. In relation to describing the present disclosure, when the detailed description of the relevant known technology is determined to unnecessarily obscure the gist of the present disclosure, the detailed description may be omitted.

The terminology used herein is for the purpose of describing particular examples only and is not intended to limit the scope of the present disclosure. As used herein, the singular forms "a", "an", and "the" are intended to comprise the plural forms as well unless the context clearly indicates otherwise. It will be further understood that the terms "comprise" or "have" when used in the present disclosure specify the presence of stated features, integers, steps, operations, elements and/or combinations thereof, but do not preclude the presence or addition of one or more other features, integers, steps, operations, elements, and/or combinations thereof.

Terms comprising ordinal numbers used in the specification, "first", "second", etc. can be used to discriminate one component from another component, but the order or priority of the components is not limited by the terms unless specifically stated. These terms are used only for the purpose of distinguishing a component from another component. For example, without departing from the scope of the present disclosure, a first component may be referred as a second component, and a second component may be also referred to as a first component.

In addition, when it is mentioned that a component is "formed" or "stacked" on another component, it should be understood such that one component may be directly attached to or directly stacked on the front surface or one surface of the other component, or an additional component may be disposed between them.

Hereinafter, the embodiment of the present disclosure shall be explained with reference to the attached drawing, and in describing it by reference to the accompanying drawing, the same or corresponding components shall be given the same figure number and the duplicate description thereof shall be omitted.

A method of preparing tellurium oxide thin film alloyed with selenium and thin film transistor using sputtering will be described in detail. However, those are described as examples, and the present disclosure is not limited thereto and is only defined by the scope of the appended claims.

One aspect of the present disclosure provides a method of preparing a semiconductor thin film, the method comprising: (a) providing a target comprising a tellurium atom (Te) and a chalcogen atom comprising at least one selected from the group consisting of a sulfur atom(S) and a selenium atom(Se); and (b) preparing the semiconductor thin film comprising an amorphous p-type semiconductor by performing co-deposition on a substrate by sputtering method using the target under an atmosphere of a mixed gas comprising an argon gas and an oxygen gas.

In addition, the step (a) may comprise (a-1) providing a first target comprising a tellurium atom (Te); and (a-2) providing a second target comprising a chalcogen atom.

In addition, the step (a) may be a step of (a') providing a target comprising a mixture of a tellurium atom (Te) and a chalcogen atom comprising at least one selected from the group consisting of a sulfur atom (S) and a selenium atom (Se).

In addition, the step (b) may comprise (b-1) discharging an argon plasma under an atmosphere of an argon gas; and (b-2) colliding the argon plasma with the first target and the second target under an atmosphere of a mixed gas comprising an argon gas and an oxygen gas to co-deposit at least one selected from the group consisting of the atom of the first target, the atom of the second target and an oxide thereof on the substrate, thereby preparing the semiconductor thin film comprising a tellurium composite.

In addition, the plasma discharge pressure of the step (b-1) may be in a range of 1 to 15 Pa. When the plasma discharge pressure is less than 1 Pa, there are not enough particles to cause the discharge, which is undesirable. When it exceeds 15 Pa, the thin film may contain impurities, which is undesirable.

In addition, a process working pressure, which is a total pressure of the argon gas and the oxygen gas in the step (b-1) or the step (b-2), may be in a range of 1 Pa or less, preferably 0.1 to 0.65 Pa. When the process working pressure exceeds 1 Pa, it is undesirable because it may produce a thin film containing impurities or having a low density, and more specifically. When it is less than 0.1 Pa, the plasma becomes unstable, which is undesirable.

In addition, a total flow rate of the argon gas and the oxygen gas in the step (b-1) or step (b-2) may be in a range of 5 to 50 sccm. When the initial flow rate is less than 5 sccm, it is undesirable because plasma generation is not easy. When the initial flow rate exceeds 50 sccm, the film uniformity deteriorates, which is undesirable.

In addition, in the step (b), a ratio (P_{O2}/ (P_{Ar}+P_{O2})) of an oxygen gas partial pressure (P_{O2}) to a total pressure of the argon gas and the oxygen gas (P_{Ar} + P_{O2}) may be in a range of 0 to 50%. When the ratio of oxygen gas partial pressure (P_{O2}) (P_{O2}/ (P_{Ar}+ P_{O2})) exceeds 50%, a tellurium dioxide (TeO₂) thin film with low hole carrier concentration is formed, which is undesirable.

In addition, in the step (b), an oxygen content of the amorphous p-type semiconductor may be regulated by controlling a ratio (P_{O2}/ (P_{Ar}+P_{O2})) of an oxygen gas partial pressure (P_{O2}) to a total pressure (P_{Ar}+P_{O2}) of the argon gas and the oxygen gas.

In addition, in the step (b-2), the power (W_{T1}) applied to the first target may be 10 to 30 W. When the power (W_{T1}) applied to the first target is less than 10 W, the plasma discharge voltage is low, which is undesirable. When it exceeds 30 W, the deposition rate is too high or damage occurs to the target, which is undesirable.

In addition, the power (W_{T2}) applied to the second target may be 1 to 9 W. When the power (W_{T2}) applied to the second target is less than 1 W, the plasma discharge voltage is low, which is undesirable. When it exceeds 15 W, the deposition rate is too high or the target is damaged, which is undesirable.

In addition, the step (b) may be carried out at room temperature.

In addition, the temperature of the substrate in the step (b) may be at a range of 5 to 50 °C. When the temperature of the substrate is below 5 °C, the effective collision energy of the thin film is lowered, making it difficult to form a thin film, which is undesirable. When it exceeds 50 °C, a crystalline thin film is formed, which is undesirable.

In addition, the method may further comprise, after the step (b): (c) annealing the semiconductor thin film at a temperature in a range of 200 to 300 °C in air. When the annealing temperature is less than 200 °C, the hole concentration of the thin film is low, which is undesirable. When it exceeds 300 °C, pinholes may be generated or excessive recrystallization may occur within the thin film, which is undesirable.

In addition, the thickness of the semiconductor thin film may be 2 to 100 nm. When the thickness of the semiconductor thin film is less than 2 nm, the charge amount is small and it is difficult to obtain sufficient thin film coverage, which is undesirable. When the thickness of the thin film is too thick, exceeding 100 nm, the charge amount is too high, which is undesirable as a semiconductor layer of a transistor.

In addition, the amorphous p-type semiconductor may comprise a chalcogen atom comprising at least one selected from the group consisting of a selenium atom (Se) and a sulfur atom (S); and a tellurium composite comprising a tellurium atom (Te) and a tellurium oxide.

In addition, the chalcogen atom may be alloyed with the tellurium composite.

In addition, the p-type semiconductor may be represented by chemical formula 1 below.

[Chemical Formula 1] TeOₓ:M

in chemical formula 1, M is sulfur atom (S) or selenium atom (Se), and x is 0.8≤x≤1.7. When x is less than 0.8, Te-Te bonds are comprised in large numbers, which increases the charge, making it undesirable as a transistor semiconductor layer. When it is greater than 1.7, the charge is too low, which is undesirable.

M may be more than 0 and 25 atom % or less for the total atoms of Te, O, and M. When M is 0 atom %, the charge is high and the off current in the device is high, which is undesirable. when it is more than 25 atom %, the hole mobility is low due to the high doping amount, which is undesirable.

In addition, the tellurium atom of the amorphous p-type semiconductor may comprise an ionization state of Te⁴⁺, an ionization state of Te²⁺, and a non-ionization state of Te⁰. Here, the semiconductor can use the shallow acceptor state formed by the 5p orbitals of Te²⁺ and Te⁰ as a hole conduction channel.

In addition, the tellurium oxide may comprise a tellurium monoxide (TeO) and a tellurium dioxide (TeO₂).

In addition, the semiconductor may be in an oxygen-deficient state. The oxygen deficiency state means a state in which the ratio of oxygen in the stoichiometry ratio of tellurium (Te): oxygen (O) is less than 1:2.

In addition, the selenium atom of the semiconductor may comprise an ionization state of Se²⁻. Here, the partially empty 4p state can be used as a hole conduction channel as the Se²⁻ of the semiconductor passivates the oxygen vacancy. At this time, the cation-anion bond of Te-Se is formed to maximize the overlap between the cation 5p orbital and the anion 4p orbital, so that the hole transfer can occur smoothly.

In addition, the semiconductor thin film may be used for a semiconductor layer of a thin film transistor.

Another aspect of the present disclosure provides a method of fabricating a thin film transistor, the method comprising: (1) preparing a laminate comprising a gate electrode and an insulating layer positioned on the gate electrode; (2) forming a semiconductor thin film prepared by the method on the insulating layer of the laminate, wherein the semiconductor thin film comprises a semiconductor; and (3) forming a source electrode and a drain electrode on the semiconductor thin film.

Another aspect of the present disclosure provides a semiconductor thin film, the semiconductor thin film may comprise an amorphous p-type semiconductor, wherein the amorphous p-type semiconductor comprises a chalcogen atom comprising at least one selected from the group consisting of a selenium atom (Se) and a sulfur atom (S), and a tellurium composite comprising a tellurium atom (Te) and a tellurium oxide.

In addition, the semiconductor may be used for a semiconductor thin film of a thin film transistor.

In addition, the thickness of the semiconductor thin film may be 2 nm or more, preferably 2 to 100 nm. When the thickness of the semiconductor thin film is less than 2 nm, the charge amount is small and it is difficult to obtain sufficient thin film coverage, which is not preferable. When the thickness of the thin film is too thick, exceeding 100 nm, the charge amount is too high, which is not preferable as a semiconductor layer of a thin film transistor.

Another aspect of the present disclosure provides a thin film transistor, which comprises: a gate electrode; an insulating layer positioned on the gate electrode; a semiconductor thin film positioned on the insulating layer and comprising a semiconductor according to the present disclosure; and a source electrode and a drain electrode positioned spaced apart from each other on the semiconductor thin film.

In addition, the gate electrode may comprise at least one selected from the group consisting of n-doped silicon (n-doped Si), p-doped silicon (p-doped Si), gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotubes (CNT), silver nanowires (Ag nanowires (Ag NW), indium tin oxide, and poly(3,4-ethylenedioxythiophene) polystyrene sulfonate (PEDOT:PSS).

In addition, the source electrode and the drain electrode may each comprise at least one selected from the group consisting of gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotubes (CNT), silver nanowires (Ag nanowires, Ag NW), indium tin oxide, and poly(3,4-ethylenedioxythiophene) polystyrene sulfonate (PEDOT:PSS).

In addition, the insulating layer may comprise at least one selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinylpyrrolidone (PVP), polyethylene (PE), silicon oxide (SiO₂), germanium, polyvinyl alcohol (PVA), polymethyl methacrylate (PMMA), zirconium oxide (ZrO₂), aluminum oxide (AlO₂), and hafnium oxide (HfO₂).

### [Examples]

Hereinafter, the examples of the present disclosure will be described. However, the examples are for illustrative purposes, and the scope of the present disclosure is not limited by the examples.

### Example: Fabrication of Amorphous p-type thin film transistor [change of Te:Se composition Ratio]

### Example 1: Te:Se=93:7 (atom %:atom %) TeOₓ:Se(x=1.31)

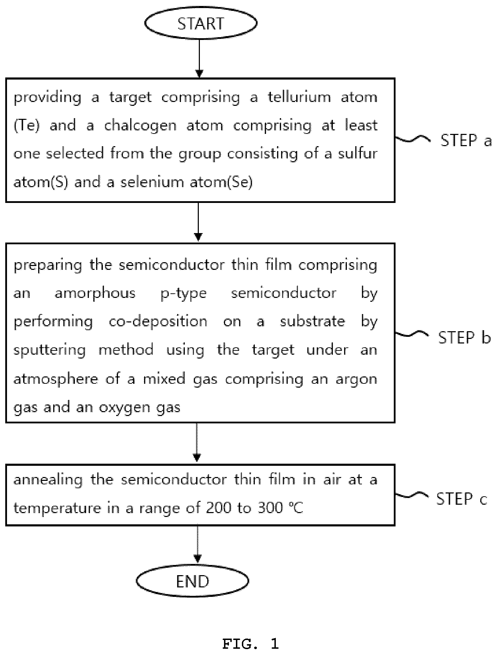

FIG. 1 is a schematic diagram showing a method for preparing a semiconductor thin film for use in a selenium-alloyed amorphous p-channel thin film transistor using a sputtering process according to the present disclosure.

Referring to FIG. 1, in order to deposit a selenium-alloyed tellurium oxide-based semiconductor film, sputtering was carried out using a Te target and a Se target simultaneously. At this time, both Te and Se used targets with a standard size of φ25.4. The plasma discharge pressure of the sputtering process was 7 Pa, the process working pressure was 0.65 Pa or less, and the reaction was carried out by supplying argon gas and oxygen. At this time, the total flow rate of argon gas and oxygen was 20 sccm, and the partial pressure of oxygen gas was 0%. The power applied to the targets during the process was 20 W for Te and 2 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited at a thickness of 25 nm or less. The deposited sample was annealed in air at 225 °C for 30 min. After that, the source/drain electrodes were each deposited using Ni to fabricate a thin film transistor (TFT). Here, the atom % ratio of Te:Se in the selenium alloy tellurium oxide TeOₓ;Se was 93:7 (atom %:atom %) and x was 1.31.

### Example 2: Te:Se=85:15 (atom %:atom %) TeOₓ;Se(x=1.17)

Referring to FIG. 1, sputtering was carried out using a Te target and a Se target simultaneously to deposit a selenium-alloyed tellurium oxide-based semiconductor film. At this time, both Te and Se used targets with a standard size of φ25.4. The plasma discharge pressure of the sputtering process was 7 Pa, the process operating pressure was 0.65 Pa or less, and the reaction was carried out by supplying argon gas and oxygen. At this time, the total flow rate of argon gas and oxygen was 20 sccm, and the partial pressure of oxygen gas was 0%. The powers applied to the targets during the process was 20 W for Te and 5 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited with a thickness of 25 nm or less. The deposited sample was annealed in air at 225 °C for 30 minutes. After that, the source/drain electrodes were each deposited using Ni to fabricate a thin film transistor (TFT). Here, the atom % ratio of Te:Se in the selenium alloy tellurium oxide, TeOₓ;Se, was 85:15 (atom %:atom %) and x was 1.17.

### Example 3: Te:Se=75:25 (atom %:atom %) TeOₓ;Se(x=0.99)

Referring to FIG. 1, sputtering was carried out using a Te target and a Se target simultaneously to deposit a selenium-alloyed tellurium oxide-based semiconductor film. At this time, both Te and Se used targets with a standard size of φ25.4. The plasma discharge pressure of the sputtering process was 7 Pa, the process operating pressure was 0.65 Pa or less, and the reaction was carried out by supplying argon gas and oxygen. At this time, the total flow rate of argon gas and oxygen was 20 sccm, and the partial pressure of oxygen gas was within 0%. The power applied to the target during the process was 20 W for Te and 8 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited with a thickness of 25 nm or less. The deposited sample was annealed in air at 225 °C for 30 minutes. After that, the source/drain electrodes were each deposited using Ni to fabricate a thin film transistor (TFT). Here, the atom % ratio of Te:Se in the selenium alloy tellurium oxide TeOₓ;Se was =75:25 (atom %:atom %) and x was 0.99.

### Example 4: Te:Se=68:32 (atom %:atom %) TeOₓ;Se

Referring to FIG. 1, sputtering was carried out using a Te target and a Se target simultaneously to deposit a selenium-alloyed tellurium oxide-based semiconductor film. At this time, both Te and Se used targets with a standard size of φ25.4. The plasma discharge pressure of the sputtering process was 7 Pa, the process working pressure was 0.65 Pa or less, and the reaction was carried out by supplying argon gas and oxygen. At this time, the total flow rate of argon gas and oxygen was 20 sccm, and the partial pressure of oxygen gas was 0%. The power applied to the targets during the process was 20 W for Te and 10 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited with a thickness of 25 nm or less. The deposited sample was annealed in air at 225 °C for 30 minutes. After that, the source/drain electrodes were each deposited using Ni to fabricate a thin film transistor (TFT). Here, the atom % ratio of Te:Se in the selenium alloy tellurium oxide, TeOₓ;Se, was 68:32 (atom %:atom %).

### Example 5: Te:Se=64:36 (atom %:atom %) TeOₓ;Se(x=1.01)

Referring to FIG. 1, sputtering was carried out using a Te target and a Se target simultaneously to deposit a selenium-alloyed tellurium oxide-based semiconductor film. At this time, both Te and Se used targets with a standard size of φ25.4. The plasma discharge pressure of the sputtering process was 7 Pa, the process working pressure was 0.65 Pa or less, and the reaction was carried out by supplying argon gas and oxygen. At this time, the total flow rate of argon gas and oxygen was 20 sccm, the partial pressure of oxygen gas was 0%, and the power applied to the target during the process was 20 W for Te and 12 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited with a thickness of 25 nm and less. The deposited sample was annealed in air at 225 °C for 30 minutes. After that, the source/drain electrodes were each deposited using Ni to fabricate a thin film transistor (TFT). Here, the atom % ratio of Te:Se in the selenium alloy tellurium oxide, TeOₓ;Se, was 64:36 (atom %:atom %) and x was 1.01.

### [Change of oxygen composition]

### Example 6: partial pressure ratio of O₂ gas/Ar gas = 0%

In order to deposit a selenium-alloyed tellurium oxide based semiconductor film, a Te target and a Se target were used simultaneously for sputtering. At this time, targets with a standard size of φ25.4 were used for both of the Te target and the Se target. The plasma discharge pressure of the sputtering process was 7 Pa, the process working pressure was 0.65 Pa or less, and the reaction was carried out at room temperature by injecting argon gas. At this time, the argon gas flow rate was 20 sccm, and the partial pressure of oxygen gas was 0%. The power applied to the targets during the process was 20 W for Te and 5 W for Se, respectively. The temperature of the substrate was 25 °C, and the distance between the target and the substrate was within about 40 cm. Pre-sputtering was carried out for about 5 minutes to clean the target surface before deposition. The selenium alloyed TeOₓ-based film was deposited with a thickness of 20 nm or less. The deposited sample was annealed in air at 225 °C for 30 minutes. After that, the source/drain electrodes were each deposited using Ni to fabricate a thin film transistor (TFT). Here, the atom % ratio of Te:Se in the selenium alloyed tellurium oxide, TeOₓ;Se, was 85:15 and x was 1.17.

### Example 7: partial pressure ratio of O₂ gas/Ar gas = 2.5%

In order to deposit a selenium-alloyed tellurium oxide based semiconductor film, a Te target and a Se target were used simultaneously for sputtering. At this time, targets with a standard size of φ25.4 were used for both Te and Se. The plasma discharge pressure of the sputtering process was 7 Pa, the process working pressure was 0.65 Pa or less, and the process was carried out at room temperature. Argon gas and oxygen gas were injected to perform the reaction. At this time, the total flow rate of argon gas and oxygen gas was 20 sccm, and the partial pressure of oxygen gas was 2.5%. The power applied to the target during the process was 20 W for Te and 5 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited with a thickness of 20 nm or less. The deposited sample was annealed in air at 225 °C for 30 minutes. After that, the source/drain electrodes were each deposited using Ni to fabricate a thin film transistor (TFT). Here, the atom % ratio of Te:Se in the selenium alloy tellurium oxide, TeOₓ;Se, was 85:15.

### Example 8: partial pressure ratio of O₂ gas/Ar gas = 5.0%

In order to deposit a selenium-alloyed tellurium oxide based semiconductor film, a Te target and a Se target were used simultaneously for sputtering. At this time, targets with a standard size of φ25.4 were used for both of the Te target and the Se target. The plasma discharge pressure of the sputtering process was 7 Pa, the process working pressure was 0.65 Pa or less, and the reaction was carried out by injecting argon gas and oxygen gas. At this time, the total flow rate of argon gas and oxygen gas was 20 sccm, and the partial pressure of oxygen gas was 5.0%. The power applied to the target during the process was 20 W for Te and 5 W for Se, respectively. The temperature of the substrate was 25 °C, and the distance between the target and the substrate was within about 40 cm. Pre-sputtering was carried out for about 5 minutes to clean the target surface before deposition. The selenium-alloyed TeOₓ-based film was deposited with a thickness of 20 nm or less. The deposited sample was annealed in air at 225 °C for 30 minutes. After that, the source/drain electrodes were each deposited using Ni to fabricate a thin film transistor (TFT). Here, the atom % ratio of Te:Se in the selenium alloyed tellurium oxide, TeOₓ;Se, was 85:15 (atom %:atom %).

### Comparative Example 1: Pristine Tellurium Oxide Te:Se=100:0 (atom %:atom %) TeOₓ(x=1.25)

Referring to Fig. 1, sputtering was carried out using a Te target to deposit a tellurium oxide-based semiconductor film. At this time, a Te target with a standard size of φ25.4 was used. The plasma discharge pressure of the sputtering process was 7 Pa, the process working pressure was 0.65 Pa or less, and the reaction was carried out by injecting argon gas and oxygen. At this time, the total flow rate of argon gas and oxygen gas was 20 sccm, and the partial pressure of argon gas was 100% or less. The power applied to the target during the process was 20 W for Te. The temperature of the substrate was 25 °C, and the distance between the target and the substrate was within about 40 cm. Pre-sputtering was carried out for about 5 minutes to clean the target surface before deposition. The TeOₓ-based film was deposited with a thickness of 25 nm or less. The deposited sample was annealed in air at 225 °C for 30 min. After that, the source/drain electrodes were each deposited using Ni to fabricate a thin film transistor (TFT). Here, the atom % ratio of Te:Se in the pristine tellurium oxide TeOₓ was 100:0 (atom %:atom %) and x was 1.25.

### [Test Example]

### Test Example 1: Analysis of the composition ratio of Te:Se in semiconductor thin films

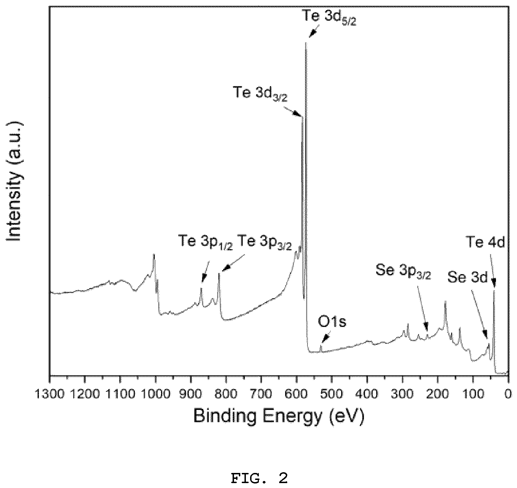

FIG. 2 shows an XPS analysis photograph of Example 6 of the present disclosure. Referring to FIG. 2 and Table 1 below, the composition ratios of Examples 1 to 8 and Comparative Example 1 were confirmed based on the areas of the peaks of Te and Se.

### Test Example 2: Measurement x of TeOₓ of semiconductor thin films

The results of measuring x of TeOₓ:Se or TeOₓ of semiconductor thin films of Examples 1 to 3, Examples 5 and 6, and Comparative Example 1 by XPS (X-ray photoelectron spectroscopy) analysis method are shown in Table 1, respectively.

### Test Example 3: Investigation of the ionization state of Se in TeOₓ: XPS analysis

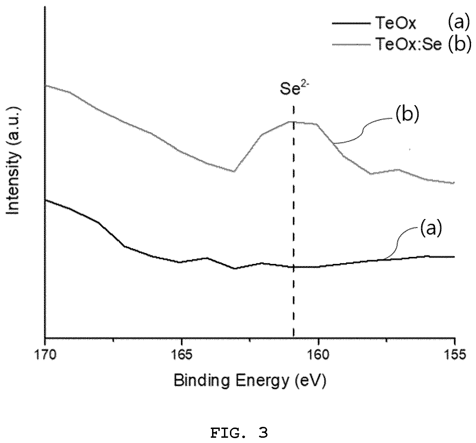

FIG. 3 shows an XPS analysis graph of Example 6 of the present disclosure and Comparative Example 1. Referring to FIG. 3, XPS was measured to find out in what state Se exists in amorphous TeOₓ, and as a result, it was confirmed that it exists in a Se²⁻ state. Through this, it can be known that Se exists in a Se-Te bond state in the TeOₓ amorphous thin film, and it can be predicted that it bonds with Te²⁺ at this time.

### Test Example 4: Se-Te Bond Analysis: Extended X-ray absorption fine structure (EXAFS)

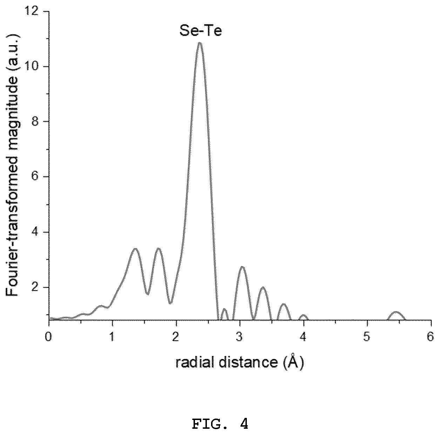

FIG. 4 is a graph showing the results of measuring the Extended X-ray absorption fine structure (EXAFS) of the thin film of Example 6 of the present disclosure. Referring to FIG. 4, when measuring the Extended X-ray absorption fine structure (EXAFS) of the thin film of Example 6, it was confirmed that a Se-Te bond state exist when looking at the intensity according to the radial distance at the Se K-edge.

### Test Example 5: XRD (X-ray Diffractometer)

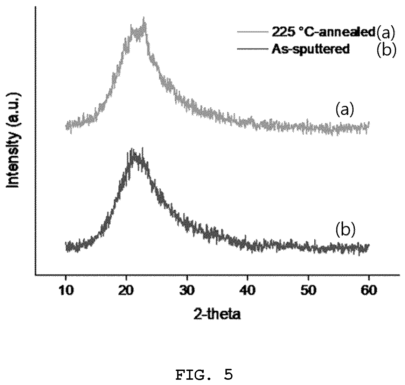

FIG. 5 is a graph showing the results of the XRD (X-ray Diffractometer) spectrum of the sample immediately after sputtering of Example 1 and the TeOₓ:Se thin film annealed at 225 °C. Referring to FIG. 5, it can be confirmed that the crystallinity of the TeOx:Se thin film is amorphous.

### Test Example 6: Band Gap Measurement

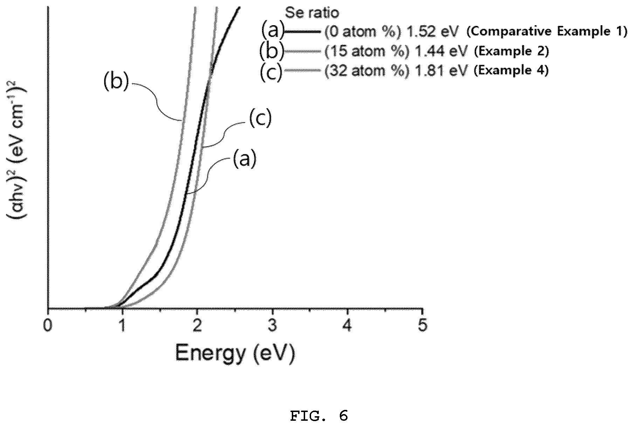

FIG. 6 is a drawing showing the band gap calculated by measuring the transmittance of the thin films according to Examples 2, 4, and Comparative Example 1 in the range of 200 nm to 2500 nm and using the tauc plot. Referring to FIG. 6, in Comparative Example 1, which is a tellurium oxide containing selenium in less than or equal to a certain alloy amount (^15%), the band gap decreases, but in Examples 2 and 4, which are more than that, the bandgap increases.

### Test Example 7: Transfer Characteristics of TeOₓ:Se TFT

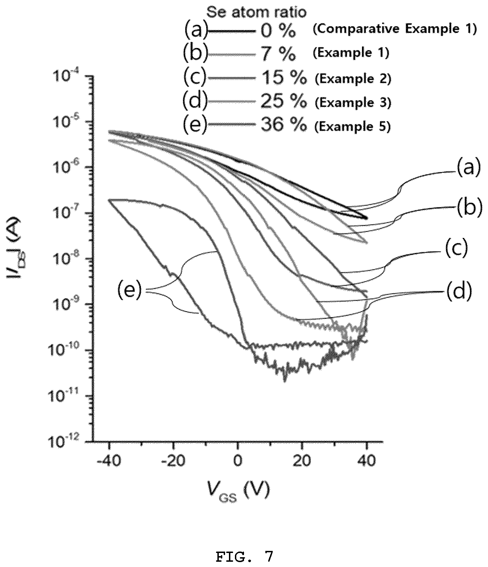

FIG. 7 is a graph showing the transfer characteristics of each according to the selenium alloy ratio of the selenium (Se)-doped TeOₓ:Se thin film transistors (TFTs) deposited by the sputtering process according to Examples 1, 2, 3, and 5 and the selenium (Se)-undoped TeOₓ thin film transistors (TFTs) according to Comparative Example 1.

Referring to FIG. 7, it was confirmed that Example 1 and Comparative Example 1, in which selenium (Se) was doped to less than 15 atom %, obtained the highest hole mobility, and it was confirmed that Examples 2, 3, and 5, in which selenium (Se) was doped to 15 atom % or more, showed a decrease in the charge amount.

Also, the hole mobility and the on/off ratio of the drain current of the TeOₓ:Se thin film transistors (TFTs) doped with selenium (Se) deposited by the sputtering process according to Examples 1, 2, 3, and 5 and the TeOx thin film transistors (TFTs) not doped with selenium (Se) according to Comparative Example 1 are as shown in Table 1 below. In Table 1, Examples 2 and 6 have the same conditions, but there is a difference in performance due to the difference in the thickness of the channel layer.

**[Table 1]**

| | TeOₓ:Se | | On/off ratio of drain current | Mobility of the hole (cm²/Vs) |
|---|---|---|---|---|
| | Te:Se composition ratio (at%:at%) | value of x | | |
| Example 1 | 93:7 | 1.31 | 2.8*10² | 5.8 |
| Example 2 | 85:15 | 1.17 | 9.2*10² | 6.7 |
| Example 3 | 75:25 | 0.99 | 6.3*10⁴ | 5.2 |
| Example 5 | 64:36 | 1.01 | 4.2*10³ | 0.5 |
| Example 6 | 85:15 | 1.17 | 3.0*10⁴ | 12.5 |
| Example 7 | 85:15 | - | 4.0*10³ | 3.3 |
| Example 8 | 85:15 | - | 1.8*10⁴ | 1.5 |
| Comparative Example 1 | 100:0 | 1.25 | 8.0*10 | 5.9 |

### Test Example 8: Transfer characteristics of TFT according to oxygen partial pressure during sputtering process

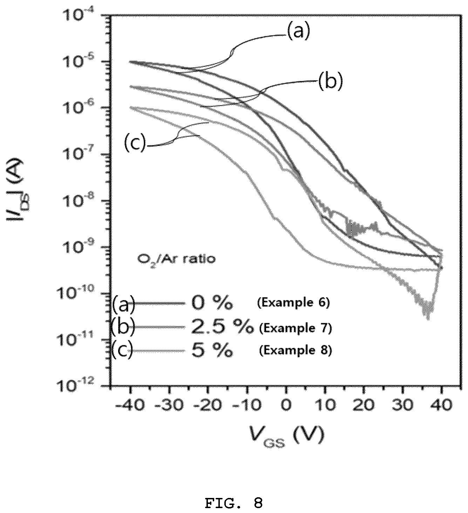

FIG. 8 is a graph showing the transfer characteristics of the device according to the oxygen partial pressure of the selenium (Se)-doped TeOₓ:Se thin film transistor (TFT) according to Examples 6, 7, and 8. Referring to FIG. 8, it can be confirmed that as the oxygen partial pressure increases, the charge of the tellurium oxide thin film decreases and the Ids curve decreases. This can be thought to be because the Te-Te bond decreases, and the charge of the film decreases.

The scope of the present disclosure is defined by the following claims rather than the above detailed description, and all changes or modifications derived from the meaning and scope of the claims and their equivalent concepts should be interpreted as falling into the scope of the present disclosure.

## Claims

1. A method of preparing a semiconductor thin film, the method comprising:
(a) providing a target comprising a tellurium atom (Te) and a chalcogen atom comprising at least one selected from the group consisting of a sulfur atom(S) and a selenium atom(Se); and
(b) preparing the semiconductor thin film comprising an amorphous p-type semiconductor by performing co-deposition on a substrate by sputtering method using the target under an atmosphere of a mixed gas comprising an argon gas and an oxygen gas.

2. The method of claim 1, wherein the step (a) comprises:
(a-1) providing a first target comprising a tellurium atom (Te) ; and
(a-2) providing a second target comprising a chalcogen atom.

3. The method of claim 1, wherein the step (a) is:
(a') providing a target comprising a mixture of a tellurium atom (Te) and a chalcogen atom comprising at least one selected from the group consisting of a sulfur atom (S) and a selenium atom (Se).

4. The method of claim 2, wherein the step (b) comprises:
(b-1) discharging an argon plasma under an atmosphere of an argon gas; and
(b-2) colliding the argon plasma with the first target and the second target under an atmosphere of a mixed gas comprising an argon gas and an oxygen gas to co-deposit at least one selected from the group consisting of the atom of the first target, the atom of the second target and an oxide thereof on the substrate, thereby preparing the semiconductor thin film comprising a tellurium composite.

5. The method of claim 4, wherein the plasma discharge pressure of the step (b-1) is in a range of 1 to 15 Pa.

6. The method of claim 4, wherein a process working pressure, which is a total pressure of the argon gas and the oxygen gas in the step (b-1) or the step (b-2), is in a range of 1 Pa or less.

7. The method of claim 4, wherein in the step (b), a ratio (P_{O2}/ (P_{Ar}+P_{O2})) of an oxygen gas partial pressure (P_{O2}) to a total pressure of the argon gas and the oxygen gas (P_{Ar} + P_{O2}) is in a range of 0 to 50%.

8. The method of claim 4, wherein in the step (b), an oxygen content of the amorphous p-type semiconductor is regulated by controlling a ratio (P_{O2}/ (P_{Ar}+P_{O2})) of an oxygen gas partial pressure (P_{O2}) to a total pressure (P_{Ar}+P_{O2}) of the argon gas and the oxygen gas.

9. The method of claim 1, wherein the amorphous p-type semiconductor comprises:
a chalcogen atom comprising at least one selected from the group consisting of a selenium atom (Se) and a sulfur atom (S); and
a tellurium composite comprising a tellurium atom (Te) and a tellurium oxide.

10. The method of claim 9, wherein the chalcogen atom is alloyed with the tellurium composite.

11. The method of claim 9, wherein the p-type semiconductor is represented by chemical formula 1 below.
[Chemical Formula 1] TeOₓ:M
in the chemical formula 1, M is sulfur atom (S) or selenium atom (Se), and x is 0.8≤x≤1.7.

12. The method of claim 9, wherein the tellurium atom of the amorphous p-type semiconductor comprises an ionization state of Te⁴⁺, an ionization state of Te²⁺, and a non-ionization state of Te⁰.

13. The method of claim 9, wherein the tellurium oxide comprises a tellurium monoxide (TeO) and a tellurium dioxide (TeO₂).

14. The method of claim 1, wherein the semiconductor is in an oxygen-deficient state.

15. A method of fabricating a thin film transistor, the method comprising:
(1) preparing a laminate comprising a gate electrode and an insulating layer positioned on the gate electrode;
(2) forming a semiconductor thin film prepared by a method of claim 1 on the insulating layer of the laminate, wherein the semiconductor thin film comprises a semiconductor; and
(3) forming a source electrode and a drain electrode on the semiconductor thin film.
